# EUROPEAN PATENT SPECIFICATION

(11) **EP 4 393 869 B1**
(45) Date of publication and mention of the grant of the patent: **07.10.2026**
(21) Application number: 22216975.7
(22) Date of filing: 28.12.2022
(51) Int. Cl.: C03B 23/24, B23K 26/21, B23K 26/53, B81B 7/00, B81C 1/00, B23K 26/20

(54) **METHOD FOR WELDING SUBSTRATES AND WELDED SUBSTRATES**
VERFAHREN ZUM SCHWEISSEN VON SUBSTRATEN UND GESCHWEISSTE SUBSTRATE
PROCÉDÉ DE SOUDAGE DE SUBSTRATS ET SUBSTRATS SOUDÉS

(43) Date of publication of application: 03.07.2024
(73) Proprietor: SCHOTT AG, 55122 Mainz (DE)
(72) Inventor: THOMAS, Jens Ulrich, 55128 Mainz (DE); MÄÄTTÄNEN, Antti, 33710 Tampere (FI); POLOJÄRVI, Ville, 33710 Tampere (FI); LAHTINEN, Ossi, 33710 Tampere (FI)
(74) Representative: Blumbach · Zinngrebe Patentanwälte PartG mbB

(56) References cited:
- EP-B1- 3 012 059
- US-A1- 2017 279 247
- US-A1- 2022 219 972
- US-A1- 2022 241 897

## Description

The invention relates to a method for welding substrates, for example glass substrates, by introducing weld lines into the substrates in contact. The invention further relates to welded substrates and to singulated chips, in particular hermetically sealed enclosures.

Singulated chips which are designed as hermetically sealed enclosures may be manufactured in larger numbers in multistep procedures. For example, two substrates in the form of larger wafers may be brought in contact, wherein functional areas and intermediate areas in between these functional areas are defined. Typically, the stacked substrates are in contact at least in the intermediate areas. The functional areas may for example be designed as cavities holding functional elements or as certain surface regions of the wafers or the like.

Before the stacked substrates are diced into multiple singulated chips, pairs of adjacent weld lines may be introduced within the intermediate areas, each weld line forming a hermetic bond between the two substrates. Dicing of the substrate stack into singulated chips may then take place in between each pair of adjacent weld lines, so that each singulated chip finally retains one surrounding weld line hermetically sealing the functional area of the singulated chip. Various methods may be used to carry out the dicing of such substrate stack.

For example, the substrates may be cut by means of a sawing blade. However, when the sawing blade runs in between the pairs of adjacent weld lines it may happen that the sawing blade occasionally comes into contact with the weld lines which may lead to the impaired hermeticity of the chips and to uneven wear of the sawing blade.

Another exemplary method of dicing may be scribing and subsequent breaking in between the pairs of adjacent weld lines. In this case, however, unclean breaking edges and chipping may occur.

Yet another exemplary method of dicing may be first pre-separating the substrates by introducing laser perforations into the substrate and then etching apart the substrates along the pre-separation lines. In this case, however, etching rates may be irregular or etching fluid may reach the bonding interface. Instead of etching, pre-separation lines may also be separated by breaking which, however, again may lead to unclean breaking edges or chipping.

US 2022/241897 A1 teaches a substrate stack including a base substrate and a cover substrate, a laser weld line for welding these substrates, and a second laser weld line for stress reduction in the first laser weld line.

US 2022/219972 A1 teaches a hermetically sealed package for thermal encapsulation of a functional area including a base substrate and a cover substrate, wherein a laser bonding line hermetically joins the substrates to one another.

US 2017/279247 A1 teaches sealed devices comprising a first glass substrate, a second glass substrate, and at least one seal between the first and second glass substrates, wherein the sealed devices may comprise a cavity containing components such as laser diodes, light emitting diodes, etc.

EP 3012059 B1 teaches two sheets put upon each other and welded together using arc welding at the level of their common boundary surface, wherein inside the arc weld, an arc like chink is made using laser ablation, other laser technique or mechanic machining to one of the sheets.

An object of the invention is to improve the process of welding substrates and/or processing into singulated chips and the singulated chips themselves, in particular to reduce or avoid the aforementioned problems. An aspect of the object is to achieve improved edges of the singulated chips, in particular improved edge-strength. Another aspect of the object is, when dicing is carried out using a sawing blade, to prevent uneven wear of the sawing blade to extend its lifetime. Another aspect of the object is, when dicing is carried out by mechanical means, to achieve more precise breaking edges and avoid chipping. Another aspect of the object is, when dicing is carried out by etching, to avoid etching fluid reaching the bonding interface and to achieve more uniform etching rates.

To solve this object, the invention discloses a method for welding substrates wherein a first and a second substrate are brought in contact with each other such that a contact area between the two substrates is formed.

Furthermore, at least two outer weld lines extending next to each other within the contact area are introduced into the first and second substrates such that the first and second substrates are welded together by each of the outer weld lines and such that a dicing area is defined between the two outer weld lines.

Furthermore, at least four inner weld lines are introduced into at least one of the two substrates extending between the two outer weld lines within the dicing area.

The inner weld lines need not necessarily weld together the first and second substrates but may also run within a volume of the substrates. However, it may be preferred that the inner weld lines or at least one or some of them also weld together the first and second substrates as will be explained in more detail later.

The first and a second substrates which are brought in contact with each other may be two individual substrates, for example a top substrate of a substrate stack to be formed and another substrate of the substrate stack to be formed, such as a bottom substrate in case the substrate stack consists of only two substrates, or an inner substrate such as a spacer substrate in case the substrate stack comprises more than two substrates.

The first and a second substrates which are brought in contact may also be an individual substrate and an outer substrate of an already existing substrate stack. It may also be the case that both first and a second substrates which are brought in contact are outer substrates of an already existing substrate stack.

Preferably, the first substrate is an integrally formed individual substrate. The second substrate may be an integrally formed individual substrate or an outer substrate of an assembled substrate stack which comprises one or more substrates.

In some embodiments of the invention, the method may further comprise dicing the welded substrates into multiple singulated chips by cutting the welded substrates within the dicing area. Preferably, the cutting may be performed on at least one of the inner weld lines extending within the dicing area.

The inner weld lines within the dicing area have several advantages, which is counterintuitive, because contact or imminent contact with weld lines during dicing is usually not desired. It is particularly surprising that the presence of inner weld lines is beneficial for different processes of dicing, so that the welding of the substrates may even be optimized in view of a later dicing but independent of the specific dicing method that will be used at a later stage. Furthermore, surprisingly, the presence of inner weld lines within the dicing zone is not detrimental for separation, thus the increased processing actually reduces the structural difference of non-intersecting and intersecting zones.

According to one exemplary dicing method, the cutting of the welded substrates may be carried out by means of a sawing blade, wherein preferably the sawing blade seizes at least one of the inner weld lines extending within the dicing area.

In this case, due to the inner weld lines in the dicing area, the sawing blade may wear more evenly. A reason is that not only the outer edges of the sawing blade may come in sporadic contact with the outer weld lines, but due to the presence of inner weld lines, a more uniform wear over the entire width of the sawing blade may result. As will be explained in more detail below, hardened material within the melting region of the weld line may increase the wear of the blade. Counterintuitively, such increased wear of the sawing blade may result in an increased lifetime of the sawing blade because inner weld lines may lead to a more uniform wear of the sawing blade allowing for consistent dicing. Moreover, due to inner weld lines, the sawing blade need not be positioned so accurately in order to keep the separation quality on level.

According to another exemplary dicing method, the cutting of the welded substrates may be carried out by scribing and subsequent breaking.

In this case, as will be explained in more detail below, the inner weld lines in the dicing area may involve heating regions surrounding the melting regions of the weld lines, which enables more precise breaking and prevents chipping.

According to another exemplary dicing method, the cutting of the welded substrates may be carried out by laser perforation in which adjacent perforations are introduced into the substrates and subsequent etching in which an etching fluid is used to connect the adjacent perforations and/or by subsequent application of stress. The latter can be achieved mechanically and/or thermally (e.g. by a CO₂ laser or a gas flame).

In this case, the inner weld lines in the dicing area may again involve heating regions surrounding the melting regions of the weld lines, which leads to more uniform etching rates and/or enables more precise breaking and prevents chipping. Moreover, the inner weld lines may prevent etching fluid reaching the bonding interface.

Generally, irrespective of the dicing method, the presence of inner weld lines in the dicing area may lead to remaining partial weld lines at the separation edge and/or remaining parts of heating or melting regions of weld lines at the separation edge, which may result in increased edge-strength of singulated chips and improved hermeticity.

The cross-section of an outer and/or inner weld line may preferably be characterized by an area of nonlinear absorption, an elongated bubble, preferably starting from the area of nonlinear absorption, a melting region, preferably surrounding the elongated bubble, and/or a heating region, preferably surrounding the elongated bubble and/or the melting region.

As described above, the invention comprises that a first and a second substrate are brought in contact such that a contact area between these substrates is formed.

Preferably, the contact area has a width of less than 5 mm, preferably of less than 2 mm, more preferably of less than 1 mm most preferably less than 0.6 mm.

Preferably, the contact area has a width of more than 0.1 mm, preferably of more than 0.4, more preferably of more than 0.6 mm.

For example, the width of the contact area may be in the range of 0.1 mm to 5 mm or in the range of 0.4mm to 2 mm or in the range of 0.6 mm to 1 mm.

As described above, between the at least two outer weld lines, in particular the two innermost outer weld lines, the dicing area is defined.

Preferably, the dicing area has a width of less than 2 mm, preferably of less than 1 mm, more preferably of less than 0.3 mm.

Preferably, the dicing area has a width of more than 0.05 mm, preferably of more than 0.1 mm, more preferably of more than 0.2 mm.

For example, the width of the dicing area may be in the range of 0.05 mm to 2 mm or in the range of 0.1 mm to 1 mm or in the range of 0.2 mm to 0.3 mm.

As described above, at least one inner weld line is introduced extending along the dicing area and between the two outer weld lines. In some embodiments, more than one inner weld line may be beneficial.

Preferably at least 8 inner weld lines are introduced.

A distance d between two adjacent inner weld lines may be smaller than 0.3 mm, preferably smaller than 0.15 mm, more preferably smaller than 0.05 mm.

In some embodiments, the inner weld lines may be introduced such that the fraction d/w is smaller than 3, preferably smaller than 2, wherein d is the distance between adjacent inner weld lines and w is the width of the dicing area. The distance d may preferably be the average distance between inner weld lines.

In some embodiments, the method for welding substrates may comprise defining a minimum shear force Fₘᵢₙ that the welding of the first and second substrates needs to withstand, and introducing a number of outer and/or inner weld lines such as to achieve the defined minimum shear force Fₘᵢₙ.

As described above, at least two outer weld lines extending along the contact area are introduced into the first and second substrates to weld them together. In other words, at least one outer weld line extends on each side of the dicing area. In some embodiments, more than one outer weld line on each side of the dicing area may be beneficial.

Preferably, at least 2 outer weld line may be introduced on each side of the dicing area, preferably at least 3 outer weld lines may be introduced on each side of the dicing area, more preferably at least 4 outer weld lines may be introduced on each side of the dicing area.

A distance d between two adjacent outer weld lines on one side of the dicing area may be smaller than 0.3 mm, preferably smaller than 0.15 mm, more preferably smaller than 0.05 mm.

Generally, the invention relates to a method for welding two substrates, wherein, preferably, at least one of the two substrates may be transparent.

In some embodiments, the first substrate, in particular the individual substrate, may comprise at least one of the following materials: glass, glass ceramic, borosilicate glass, crystal, sapphire, diamond.

In some embodiments, the second substrate may comprise at least one of the following materials: glass, glass ceramic, borosilicate glass, crystal, sapphire, diamond, silicon, metal.

The two substrates which are brought into contact may for example be in the form of larger wafers which may be diced into a plurality of singulated chips. For example, wafers may be employed which have a thickness in the range of 0.3 mm to 1 mm and a lateral dimension in the range of 150 mm to 250 mm, wherein such wafers may be round.

In some embodiments, the first and/or second substrate may have a thickness in the range of 0.03 mm to 20 mm, preferably in the range of 0.1 mm to 4 mm, more preferably in the range of 0.2 mm to 2 mm.

In some embodiments, the first and/or second substrate may have a lateral dimension in the range of 30 mm to 1000 mm, preferably in the range of 50 mm to 500 mm.

In some embodiments, a plurality of dicing areas may be introduced into the two substrates. In such cases, the welded substrates may be diced into a plurality of singulated chips.

Preferably, such plurality of dicing areas may define a grid, wherein dicing areas may preferably extend orthogonal with respect to each other.

The invention further discloses a welded substrate comprising at least a first substrate and a second substrate, wherein the first and second substrates are in contact with each other such that a contact area between the two substrates is formed.

At least two outer weld lines extend next to each other within the contact area within the first and second substrates such that the first and second substrates are welded together by each of the outer weld lines and such that a dicing area is defined between the two outer weld lines.

At least four inner weld lines extend between the two outer weld lines within the dicing area within at least one of the two substrates.

Preferably, one or more functional areas are defined which each are hermetically enclosed by the dicing areas.

The first and a second substrates being in contact may be two individual substrates or may be an individual substrate and an outer substrate of a substrate stack or may be two outer substrates of two substrate stacks. Thus, the welded substrates as described may comprise further substrates.

For example, the welded substrates may comprise a third substrate, wherein the second and third substrates are in contact with each other such that a contact area between these two substrates is formed.

At least two outer weld lines may extend next to each other within the contact area within the second and third substrates such that the second and third substrates are welded together by each of the outer weld lines and such that a dicing area is defined between the two outer weld lines.

One or more inner weld lines may extend between the two outer weld lines within this dicing area within at least one of the two substrates.

Preferably, one or more cavities are defined which each are hermetically enclosed by the dicing areas.

Preferably, such cavities may be laterally enclosed by a spacer substrate comprising one or more cavities extending over the entire thickness of the spacer substrate.

The invention further discloses a singulated chip, in particular a hermetically sealed enclosure, comprising at least a first substrate and a second substrate, wherein the first and second substrates are in contact with each other and are welded together by weld lines.

A functional area is defined which is hermetically enclosed by weld lines. These weld lines weld together first and second substrates.

At least two further weld lines or partial weld lines are positioned at the lateral edge of at least one substrate. Such weld line or partial weld line may be the result of previously introduced inner weld lines and need not necessarily weld together the first and second substrates but may also run within a volume of the substrates.

The singulated chip may comprise further substrates. For example, a third substrate, wherein the second and third substrates are in contact with each other and are welded together by weld lines.

A cavity may be defined which is hermetically enclosed by weld lines. These weld lines weld together the substrates.

Preferably, such cavity may be laterally enclosed by a spacer substrate comprising a cavity extending over the entire thickness of the spacer substrate.

At least one weld line or a partial weld line may be positioned at the lateral edge of at least one substrate.

Such weld line or partial weld line may be the result of previously introduced inner weld lines and need not necessarily weld together the substrates but may also run within a volume of the substrates.

In what follows, aspects of the invention are described with respect to the figures for better understanding of the invention. Embodiments of the invention are shown in Figs. 11, 14-18.
- FIG. 1:: shows a perspective view of a two-wafer stack, wherein pairs of outer weld lines are introduced to weld together the two wafers, and wherein inner weld lines are introduced extending between the pairs of outer weld lines,
- FIG. 2:: shows an exploded view of a singulated chip manufactured by dicing the welded two wafers shown in FIG. 1,
- FIG. 3:: shows a partial sectional view of a singulated chip manufactured by dicing the welded two wafers shown in FIG. 1,
- FIG. 4:: shows a perspective view of a three-wafer stack, wherein pairs of outer weld lines are introduced to weld together the upper two wafers, and wherein inner weld lines are introduced extending between the pairs of outer weld lines,
- FIG. 5:: shows an exploded view of a singulated chip manufactured by dicing the welded three wafers shown in FIG. 4,
- FIG. 6:: shows a partial sectional view of a singulated chip manufactured by dicing the welded two wafers shown in FIG. 4,
- FIG. 7:: shows a perspective view of a singulated chip manufactured by dicing the welded three wafers shown in FIG. 4,
- FIG. 8:: shows a sectional view of a singulated chip manufactured by dicing the welded two wafers shown in FIG. 4,
- FIG. 9:: shows several perspective views to illustrate exemplary steps (a), (b), (c), (d) for the fabrication of singulated chips from initial wafers,
- FIG. 10:: shows a schematic view of pairs of outer weld lines defining dicing areas, wherein a single inner weld line extends within a dicing area,
- FIG. 11:: shows a schematic view of pairs of outer weld lines defining dicing areas, wherein multiple inner weld line extend within a dicing area,
- FIG. 12:: shows a sectional view of two welded substrates, wherein inner weld lines extend over both substrates,
- FIG. 13:: shows a sectional view of two welded substrates, wherein inner weld lines extend within the volume of a single substrate,
- FIG. 14:: shows a sectional view of two welded substrates, wherein the distance between inner weld lines is adjusted to the width of the dicing area,
- FIG. 15:: shows a sectional view of a weld line,
- FIG. 16:: shows an image of a first exemplary embodiment of welded substrates,
- FIG. 17:: shows an image of a second exemplary embodiment of welded substrates,
- FIG. 18:: shows two images (a), (b) of third exemplary embodiments of welded substrates.

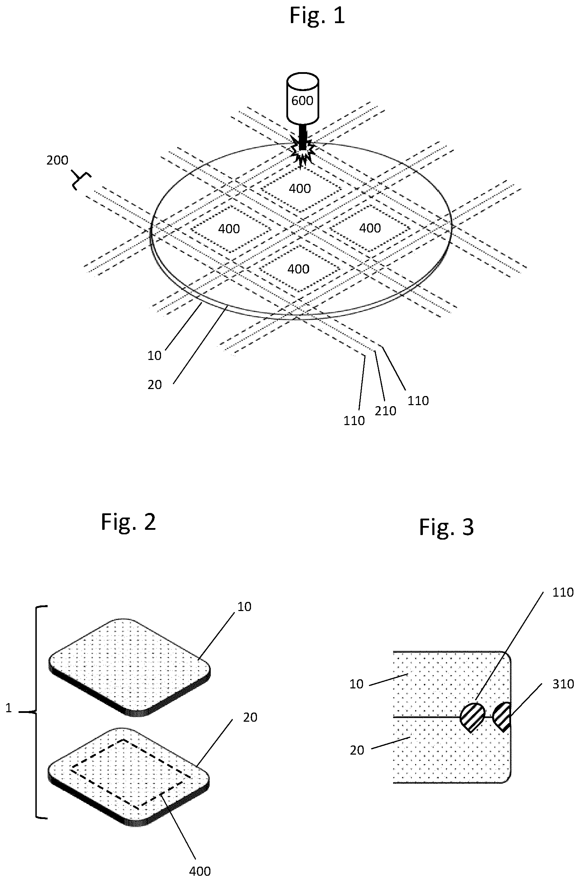

FIG. 1 shows a first substrate 10 in the form of a wafer and a second substrate 20 in the form of a wafer, wherein the substrates 10, 20 are stacked on top of each other. By means of a laser 600, pairs of outer weld lines 110 are introduced into the first and second substrates 10, 20 such that the first and second substrates 10, 20 are welded together. Again, by means of a laser 600, inner weld lines 210 extending between a pair of outer weld lines 110 are introduced into at least one of the two substrates 10, 20. In areas closed all around by weld lines, functional areas 400 are defined.

These functional areas 400 can be singulated by dicing the welded substrates 10, 20 between the functional areas 400 within dicing areas 200 extending between outer weld lines 110. Dicing the welded substrates 10, 20 into multiple singulated chips 1 can be carried out by different cutting methods such as by means of a sawing blade, scribing and subsequent breaking, laser perforation and subsequent etching or subsequent breaking or the like. When cutting the welded substrates along a cutting trench, at least one of the inner weld lines 210 extending within the dicing area 200 may be seized by the cutting method.

FIGS. 2 and 3 show a singulated chip 1 manufactured by dicing the welded two wafers 10, 20. The singulated chip 1 comprises a first substrate 10, a second substrate 20 and a functional area 400 which is hermetically enclosed by surrounding weld lines 110, 310, one of which being a partial weld line 310 directly positioned at the lateral edge of the singulated chip 1.

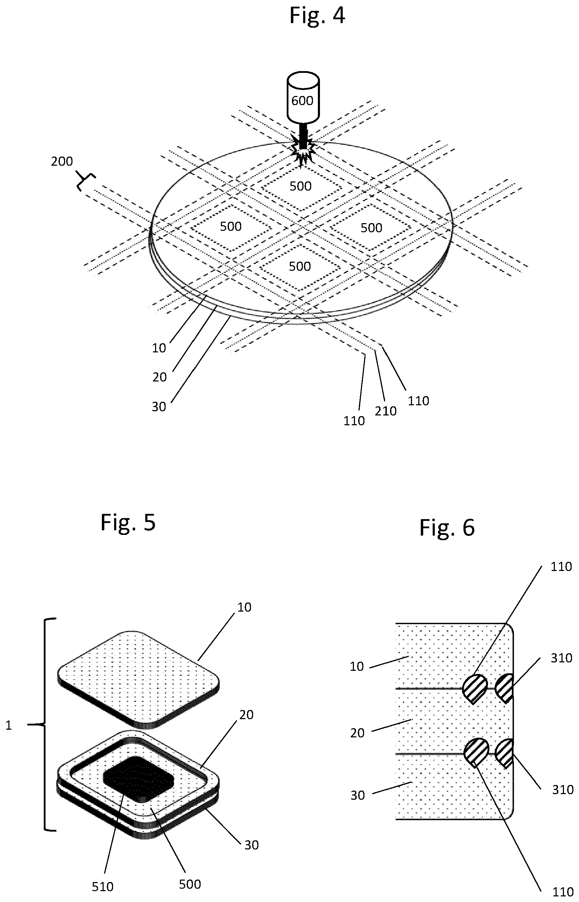

FIG. 4 shows three wafers 10, 20, 30, wherein the lower two wafers 20, 30 are already an assembled wafer stack of two substrates being welded together. The upper wafer 10 is an individual wafer which is brought in contact with the outer wafer 20 of the lower wafer stack. By means of a laser 600, outer weld lines 110 are introduced into the upper individual wafer 10 and the outer wafer 20 of the lower wafer stack so as to weld together the two wafers 10, 20. Again, by means of a laser 600, inner weld lines 210 extending between a pair of outer weld lines 110 are introduced into at least one of the two substrates 10, 20.

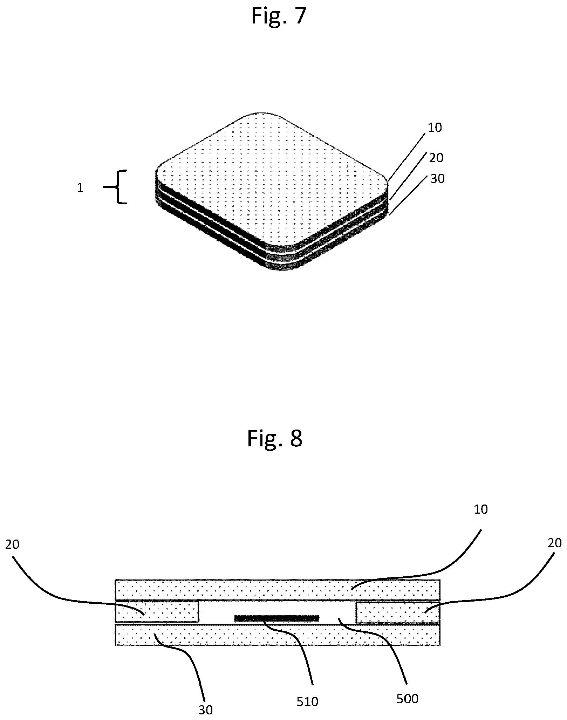

FIGS. 5 to 8 show a singulated chip 1 manufactured by dicing the welded wafer stack 10, 20, 30. The singulated chip 1 comprises an upper first substrate 10, an intermediate second substrate 20 and a lower third substrate 30, wherein the intermediate second substrate 20 is a spacer substrate comprising a cavity 500 extending through the entire thickness of the spacer substrate. The cavity 500 may house a functional element 510, e.g. a microchip. The cavity 500 is hermetically sealed by surrounding weld lines 110, 310 bonding the first and second substrates 10, 20 as well as the second and third substrates 20, 30. At the lateral edge, the singulated chip 1 comprises several partial weld lines 310.

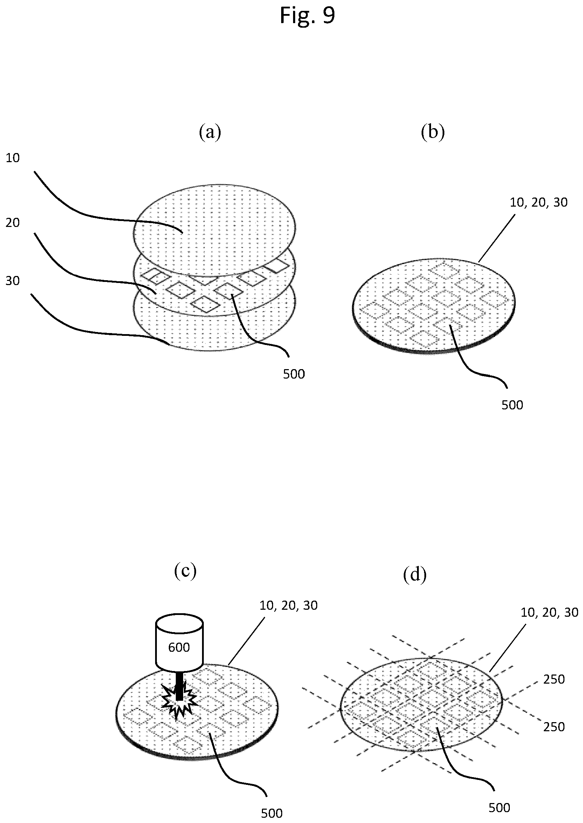

FIG. 9 shows several exemplary steps for the fabrication of singulated chips from initial wafers, in this case three wafers 10, 20, 30. In step (a) some or all of the wafers are aligned with respect to each other and/or with respect to components to be sealed. For example, spacer wafer 20 comprising cavities 500 may be aligned with respect to functional components attached on lower wafer 30 and upper wafer 10 may be aligned with respect to spacer wafer 20 and/or lower wafer 30. In step (b) the wafers 10, 20, 30 are brought into contact such that contact areas are defined between adjacent wafers, in this case between wafers 10, 20 and between wafers 20, 30. In step (c) adjacent wafers 10, 20 and 20, 30 are welded together by means of a laser 600, wherein weld lines are introduced in the contact area as described further above. In step (d) welded wafer stack 10, 20, 30 may be diced into multiple singulated chips, wherein dicing may be carried out along dicing trenches 250 extending along the contact areas comprising the weld lines.

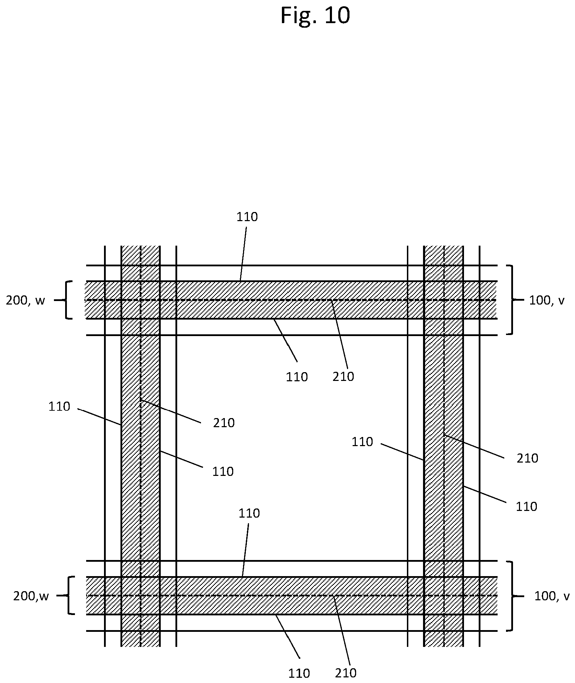

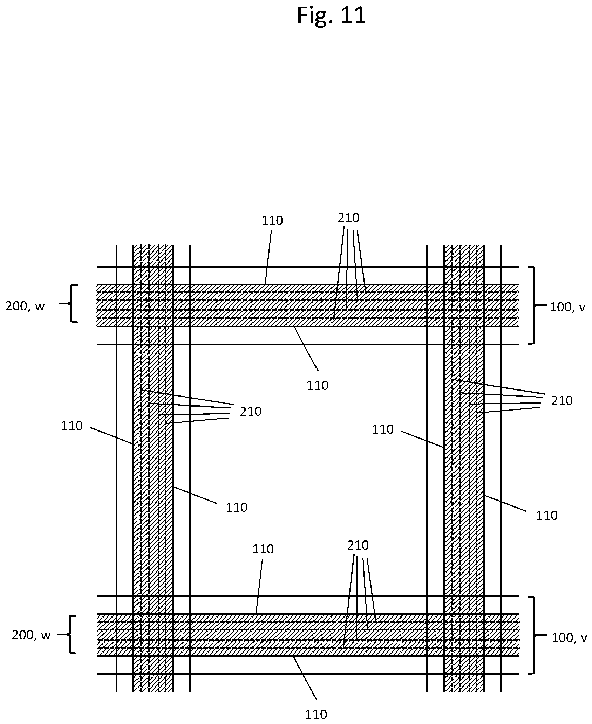

FIGS. 10 and 11 show contact areas 100 between two substrates and pairs of outer weld lines 110 introduced within these contact areas 100, wherein the outer weld lines 110 are the outermost weld lines 110 adjacent to the two edges of the contact area 100. The contact area has a width v. In between these outer weld lines 110 a dicing area 200 is defined which is intended for cutting and dicing the welded substrates, preferably without impairing the outer weld lines 110. The dicing area has a width w, wherein w<=v, preferably w<v. Within the dicing area 200, one or more inner weld lines 210 is introduced, for example one inner weld lines 210 (FIG. 10) or four inner weld lines 210 (FIG. 11). An advantage of less weld lines may be a shorter production time. Preferably, cutting the welded substrates is carried out on one or more inner weld lines 210, so that partial weld lines 310 remain at the edges of the singulated chips 1.

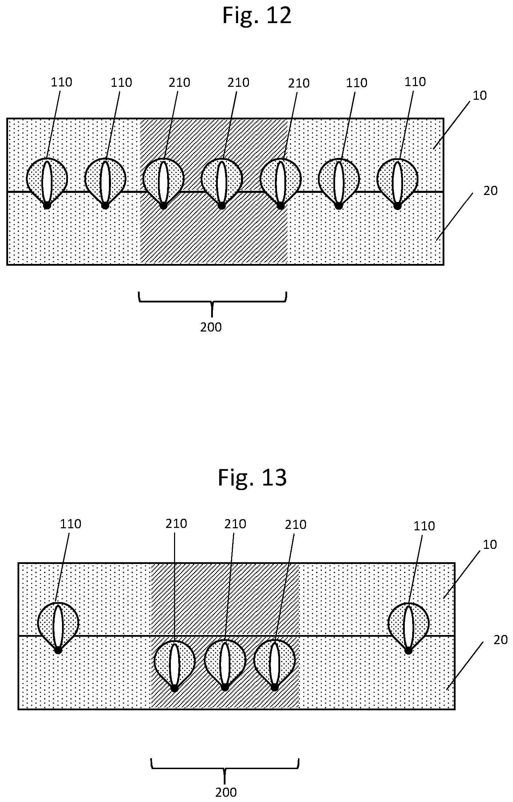

FIG. 12 shows an embodiment of two welded substrates 10, 20, wherein two outer weld lines 110 are introduced on each side of the dicing area 200 and multiple inner weld lines 210 are introduced within the dicing area 200. In this case, inner weld lines 210 are positioned at equal distances and at equal focal positions, i.e., at equal depths within the substrates, relative to the outer weld lines 110. In this case, both the outer weld lines 110 and the inner weld lines 210 are positioned at the interface of the two substrates 10, 20 and thus weld together the two substrates 10, 20.

FIG. 13 shows an embodiment of two welded substrates 10, 20, wherein a single outer weld line 110 is introduced on each side of the dicing area 200 and multiple inner weld lines 210 are introduced within the dicing area 200. In this case, inner weld lines 210 have a greater distance to the outer weld lines 110 than inner weld lines 210 have with respect to each other. Furthermore, inner weld lines are positioned within the volume of one of the substrates, in this case the lower substrate 20. Thus, inner weld lines are not contributing to welding together the two substrates 10, 20. An advantage may be that material in the separation zone is easier to separate from singulated chips, since it falls apart.

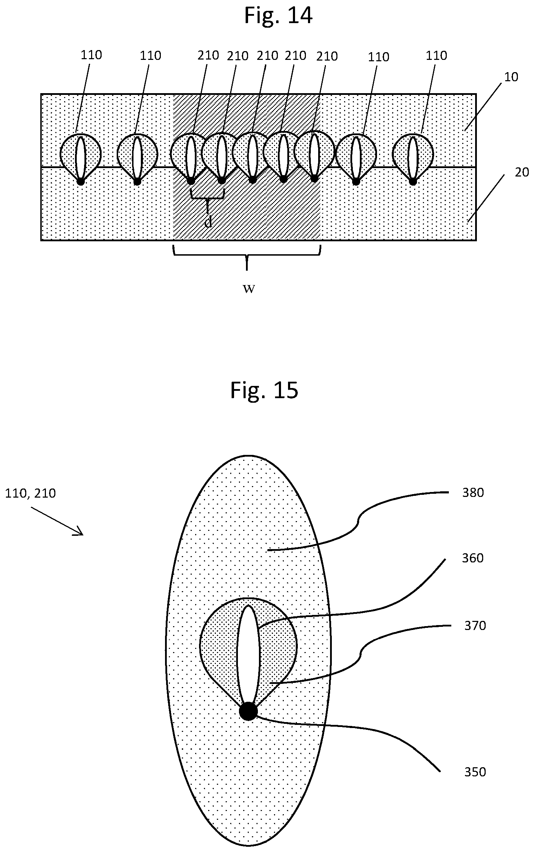

FIG. 14 shows an embodiment of two welded substrates 10, 20, with outer weld lines 110 and inner weld lines 210 introduced in the two substrates. The inner weld lines preferably are introduced such that the fraction d/w is smaller than 3, preferably smaller than 2, wherein d is the distance between adjacent inner weld lines 210 and w is the width of the dicing area 200. As described above, at least one or some of the inner weld lines may be in the plane of the outer weld lines and/or may be entirely in the volume of one of the substrates.

FIG 15 shows a weld line, wherein the weld line comprises several regions or areas such an area of nonlinear absorption 350, an elongated bubble 360, preferably starting from the area of nonlinear absorption, a melting region 370, preferably surrounding the elongated bubble, and/or a heating region 380, preferably surrounding the elongated bubble and/or the melting region.

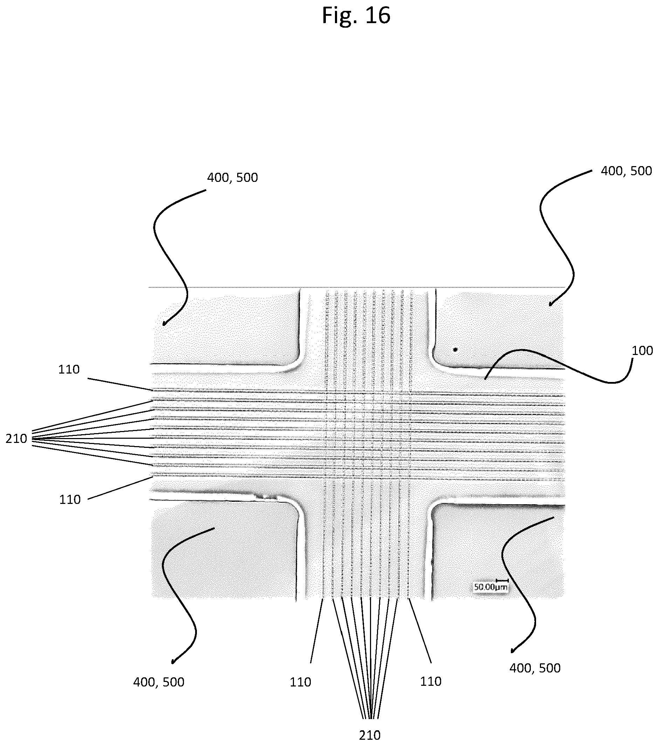

FIG 16 shows an image of a first exemplary embodiment of welded substrates defining functional areas 400 and/or cavities 500 between contact areas 100 and comprising several weld lines forming an orthogonal grid. In this case, the weld line pitch is in a range of 20 µm to 60 µm, for example 40 µm. The width of the weld zone is between 250 µm and 450 µm, for example 360 µm.

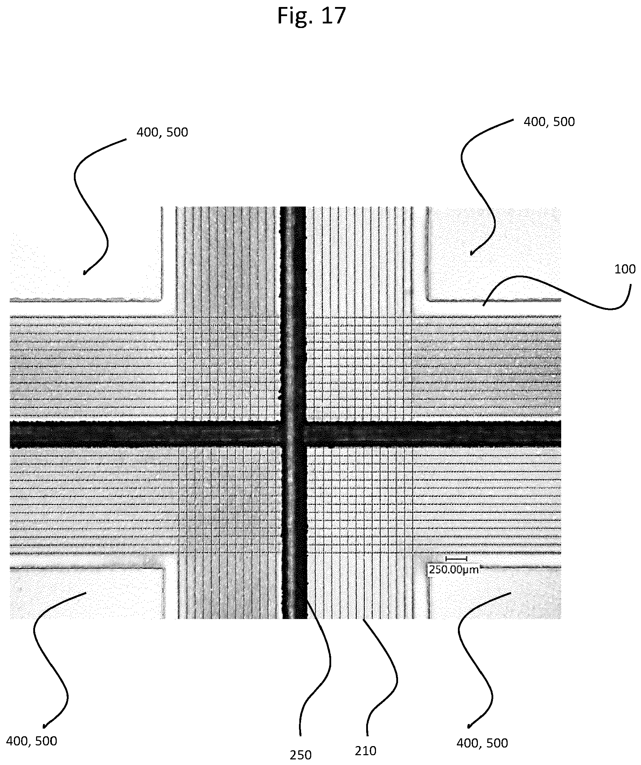

FIG 17 shows an image of a second exemplary embodiment of welded substrates defining functional areas 400 and/or cavities 500 between contact areas 100 and comprising several weld lines forming an orthogonal grid. In this case, the weld line pitch is in a range of 20 µm to 200 µm, for example 100 µm. The width of the weld zone is between 50 µm and 5000 µm, for example 3000 µm. The width of a dicing trench 250 is between 150 µm and 450 µm, for example 310 µm.

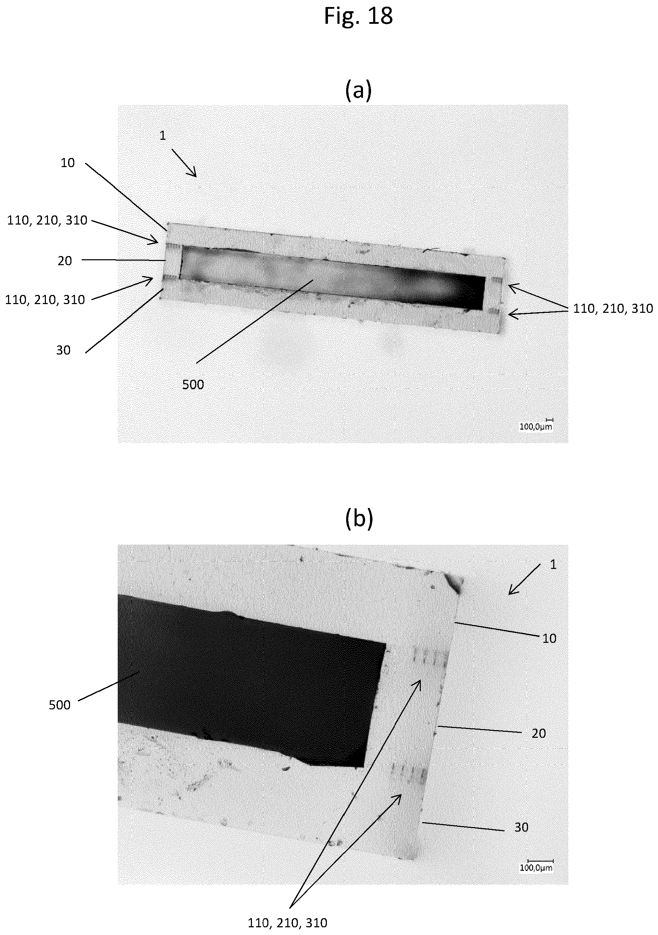

FIG 18 shows embodiments of a singulated glass enclosure 1. It has been cut in half and polished at the cutting side in order to show the weld lines in the microscope pictures. It is comprised of three substrates 10, 20, 30 welded together by weld lines 110, 210, 310. The substrates, in this case, are made of Borofloat33^{™} glass with thicknesses of 320 µm, 500 µm and 320 µm respectively, that enclose a cavity 500. In this case, as in FIG 16, the weld line pitch is in a range of 20 µm to 60 µm, for example 40 µm. The width of the weld zone is between 250 µm and 450 µm, for example 360 µm. The singulation has been done with a dicing saw.

### List of reference signs

- 1: Singulated chip
- 10: First substrate
- 20: Second substrate
- 30: Third substrate
- 100: Contact area of width v
- 110: Outer weld line
- 200: Dicing area of width w
- 210: Inner weld line
- 250: Dicing trench
- 310: Partial weld line
- 350: Area of nonlinear absorption
- 360: Elongated bubble
- 370: Melting region
- 380: Heating region
- 400: Functional area
- 500: Cavity
- 510: Functional element
- 600: Laser

## Claims

1. Method for welding substrates comprising:
Bringing a first substrate (10) and a second substrate (20) in contact with each other such that a contact area (100) between the two substrates is formed,
Introducing at least two outer weld lines (110) extending next to each other within the contact area (100) into the first and second substrates (10, 20) such that the first and second substrates (10, 20) are welded together by each of the outer weld lines (110) and such that a dicing area (200) is defined between the two outer weld lines (110),
Introducing at least four inner weld lines (210) extending between the two outer weld lines (110) within the dicing area into at least one of the two substrates.

2. Method according to any one of the preceding claims, further comprising:
Dicing the welded substrates into multiple singulated chips by cutting the welded substrates within the dicing area,
wherein preferably the cutting is performed on at least one of the inner weld lines extending within the dicing area.

3. Method according to any one of the preceding claims,
wherein the cutting of the welded substrates is carried out by means of a sawing blade,
wherein preferably the sawing blade seizes at least one of the inner weld lines extending within the dicing area.

4. Method according to any one of the preceding claims,
wherein the cutting of the welded substrates is carried out by scribing and subsequent breaking.

5. Method according to any one of the preceding claims,
wherein the cutting of the welded substrates is carried out by laser perforation in which adjacent perforations are introduced into the substrates and subsequent etching in which an etching fluid is used to connect the adjacent perforations and/or by subsequent application of stress, e.g. mechanical stress and/or thermal stress.

6. Method according to any one of the preceding claims,
wherein the cross-section of an outer and/or inner weld line is **characterized by** at least one of the following features:
an area of nonlinear absorption (350),
an elongated bubble (360), preferably starting from the area of nonlinear absorption,
a melting region (370), preferably surrounding the elongated bubble,
a heating region (380), preferably surrounding the elongated bubble and/or the melting region.

7. Method according to any one of the preceding claims, wherein the contact area has a width of less than 5 mm, preferably of less than 2 mm, more preferably of less than 1 mm most preferably less than 0.6 mm and/or
wherein the contact area has a width of more than 0.1 mm, preferably of more than 0.4, more preferably of more than 0.6 mm.

8. Method according to any one of the preceding claims,
wherein the dicing area has a width of less than 2 mm, preferably of less than 1 mm, more preferably of less than 0.3 mm and/or
wherein the dicing area has a width of more than 0.05 mm, preferably of more than 0.1 mm, more preferably of more than 0.2 mm.

9. Method according to any one of the preceding claims,
wherein at least 8 inner weld lines are introduced, and/or
wherein two adjacent inner weld lines have a distance d to each other which is smaller than 0.3 mm, preferably smaller than 0.15 mm, more preferably smaller than 0.05 mm, and/or
wherein the inner weld lines are introduced such that the fraction d/w is smaller than 3, preferably smaller than 2, wherein d is the distance between adjacent inner weld lines and w is the width of the dicing area.

10. Method according to any one of the preceding claims, further comprising:
defining a minimum shear force Fₘᵢₙ that the welding of the first and second substrates needs to withstand, and
introducing a number of outer and/or inner weld lines such as to achieve the defined minimum shear force Fₘᵢₙ.

11. Method according to any one of the preceding claims,
wherein at least 2 outer weld line is introduced on each side of the dicing area, preferably at least 3 outer weld lines are introduced on each side of the dicing area, more preferably at least 4 outer weld lines are introduced on each side of the dicing area, and/or
wherein two adjacent outer weld lines have a distance d to each other which is smaller than 0.3 mm, preferably smaller than 0.15 mm, more preferably smaller than 0.05 mm.

12. Method according to any one of the preceding claims,
wherein the first substrate comprises one of the following materials: glass, glass ceramic, borosilicate glass, crystal, sapphire, diamond and/or
wherein the second substrate comprises one of the following materials: glass, glass ceramic, borosilicate glass, crystal, sapphire, diamond, silicon, metal.

13. Method according to any one of the preceding claims,
wherein the first and/or second substrate has a thickness in the range of 0.03 mm to 20 mm, preferably in the range of 0.1 mm to 4 mm, more preferably in the range of 0.2 mm to 2 mm and/or
wherein the first and/or second substrate have a lateral dimension in the range of 30 mm to 1000 mm, preferably in the range of 50 mm to 500 mm.

14. Method according to any one of the preceding claims,
wherein a plurality of dicing areas are introduced into the two substrates,
wherein preferably the plurality of dicing areas defines a grid.

15. Welded substrates comprising:
at least a first substrate (10) and a second substrate (20),
wherein the first and second substrates (10, 20) are in contact with each other such that a contact area (100) between the two substrates is formed,
at least two outer weld lines (110) extending next to each other within the contact area (100) within the first and second substrates (10, 20) such that the first and second substrates (10, 20) are welded together by each of the outer weld lines and such that a dicing area (200) is defined between the two outer weld lines,
at least four inner weld lines (210) extending
between the two outer weld lines (110) within the dicing area (200) within at least one of the two substrates (10, 20).

16. Welded substrates according to the preceding claim further comprising:
a third substrate (30),
wherein the second and third substrates (20, 30) are in contact with each other such that a contact area (200) between the two substrates is formed,
at least two outer weld lines (110) extending next to each other within the contact area (200) within the second and third substrates (20, 30) such that the second and third substrates (20, 30) are welded together by each of the outer weld lines and such that a dicing area (200) is defined between the two outer weld lines,
one or more inner weld lines (210) extending
between the two outer weld lines (110) within the dicing area 200) within at least one of the two substrates (20, 30).

17. Singulated chip (1), in particular hermetically sealed enclosure, comprising
at least a first substrate (10) and a second substrate (20),
wherein the first and second substrates (10, 20) are in contact with each other and are welded together by weld lines,
wherein a functional area (400) is defined which is hermetically enclosed by weld lines, and wherein at least two further weld lines or partial weld lines (310) are positioned at the lateral edge of at least one substrate.

18. Singulated chip (1) according to the preceding claim further comprising:
a third substrate (30),
wherein the second and third substrates (20, 30) are in contact with each other and are welded together by weld lines,
wherein a cavity (500) is defined which is hermetically enclosed by weld lines, and wherein at least one weld line or a partial weld line (310) is positioned at the lateral edge of at least one substrate.

## Patentansprüche

1. Verfahren zum Verschweißen von Substraten, umfassend:
In-Kontakt-Bringen eines ersten Substrats (10) und eines zweiten Substrats (20) miteinander, so dass ein Kontaktbereich (100) zwischen den beiden Substraten gebildet wird,
Einbringen von mindestens zwei äußeren Schweißlinien (110), die nebeneinander innerhalb des Kontaktbereichs (100) verlaufen, in das erste und das zweite Substrat (10, 20), so dass das erste und das zweite Substrat (10, 20) durch jede der äußeren Schweißlinien (110) miteinander verschweißt werden und so dass ein Vereinzelungsbereich (200) zwischen den beiden äußeren Schweißlinien (110) definiert wird,
Einbringen von mindestens vier inneren Schweißlinien (210), die zwischen den beiden äußeren Schweißlinien (110) innerhalb des Vereinzelungsbereichs verlaufen, in mindestens eines der beiden Substrate.

2. Verfahren nach einem der vorhergehenden Ansprüche, ferner umfassend:
Vereinzeln der verschweißten Substrate in mehrere vereinzelte Chips durch Trennen der verschweißten Substrate innerhalb des Vereinzelungsbereichs,
wobei bevorzugt das Trennen an mindestens einer der innerhalb des Vereinzelungsbereichs verlaufenden inneren Schweißlinien erfolgt.

3. Verfahren nach einem der vorhergehenden Ansprüche,
wobei das Trennen der verschweißten Substrate mittels eines Sägeblatts erfolgt,
wobei das Sägeblatt bevorzugt mindestens eine der innerhalb des Vereinzelungsbereichs verlaufenden inneren Schweißlinien erfasst.

4. Verfahren nach einem der vorhergehenden Ansprüche,
wobei das Trennen der verschweißten Substrate durch Ritzen und anschließendes Brechen erfolgt.

5. Verfahren nach einem der vorhergehenden Ansprüche,
wobei das Trennen der verschweißten Substrate mittels Laserperforation erfolgt, bei der benachbarte Perforationen in die Substrate eingebracht werden, und durch anschließendes Ätzen, bei dem eine Ätzflüssigkeit verwendet wird, um die benachbarten Perforationen zu verbinden, und/oder durch anschließendes Aufbringen einer Spannung, z. B. einer mechanischen Spannung und/oder thermischen Spannung.

6. Verfahren nach einem der vorhergehenden Ansprüche,
wobei der Querschnitt einer äußeren und/oder inneren Schweißlinie durch mindestens eines der folgenden Merkmale gekennzeichnet ist:
einen Bereich nichtlinearer Absorption (350),
eine längliche Blase (360), bevorzugt ausgehend von dem Bereich nichtlinearer Absorption,
einen Schmelzbereich (370), bevorzugt die längliche Blase umgebend,
einen Erwärmungsbereich (380), bevorzugt die längliche Blase und/oder den Schmelzbereich umgebend.

7. Verfahren nach einem der vorhergehenden Ansprüche,
wobei der Kontaktbereich eine Breite von weniger als 5 mm, bevorzugt von weniger als 2 mm, weiter bevorzugt von weniger als 1 mm, am meisten bevorzugt von weniger als 0,6 mm aufweist, und/oder
wobei der Kontaktbereich eine Breite von mehr als 0,1 mm, bevorzugt von mehr als 0,4 mm, weiter bevorzugt von mehr als 0,6 mm aufweist.

8. Verfahren nach einem der vorhergehenden Ansprüche,
wobei der Vereinzelungsbereich eine Breite von weniger als 2 mm, bevorzugt von weniger als 1 mm, weiter bevorzugt von weniger als 0,3 mm aufweist, und/oder
wobei der Vereinzelungsbereich eine Breite von mehr als 0,05 mm, bevorzugt von mehr als 0,1 mm, weiter bevorzugt von mehr als 0,2 mm aufweist.

9. Verfahren nach einem der vorhergehenden Ansprüche,
wobei mindestens 8 innere Schweißlinien eingebracht werden, und/oder
wobei zwei benachbarte innere Schweißlinien einen Abstand d zueinander aufweisen, der kleiner als 0,3 mm, bevorzugt kleiner als 0,15 mm, weiter bevorzugt kleiner als 0,05 mm ist, und/oder
wobei die inneren Schweißlinien derart eingebracht werden, dass der Quotient d/w kleiner als 3, bevorzugt kleiner als 2 ist, wobei d der Abstand zwischen benachbarten inneren Schweißlinien ist und w die Breite des Vereinzelungsbereichs ist.

10. Verfahren nach einem der vorhergehenden Ansprüche, ferner umfassend:
Definieren einer Mindest-Scherkraft Fₘᵢₙ, der die Verschweißung des ersten und des zweiten Substrats standhalten muss, und
Einbringen einer Anzahl von äußeren und/oder inneren Schweißlinien in solcher Weise, dass die definierte Mindest-Scherkraft Fₘᵢₙ erreicht wird.

11. Verfahren nach einem der vorhergehenden Ansprüche,
wobei mindestens 2 äußere Schweißlinien auf jeder Seite des Vereinzelungsbereichs eingebracht werden, bevorzugt mindestens 3 äußere Schweißlinien auf jeder Seite des Vereinzelungsbereichs eingebracht werden, weiter bevorzugt mindestens 4 äußere Schweißlinien auf jeder Seite des Vereinzelungsbereichs eingebracht werden, und/oder
wobei zwei benachbarte äußere Schweißlinien einen Abstand d zueinander aufweisen, der kleiner als 0,3 mm, bevorzugt kleiner als 0,15 mm, weiter bevorzugt kleiner als 0,05 mm ist.

12. Verfahren nach einem der vorhergehenden Ansprüche,
wobei das erste Substrat eines der folgenden Materialien umfasst: Glas, Glaskeramik, Borosilikatglas, Kristall, Saphir, Diamant; und/oder
wobei das zweite Substrat eines der folgenden Materialien umfasst: Glas, Glaskeramik, Borosilikatglas, Kristall, Saphir, Diamant, Silizium, Metall.

13. Verfahren nach einem der vorhergehenden Ansprüche,
wobei das erste und/oder das zweite Substrat eine Dicke im Bereich von 0,03 mm bis 20 mm, bevorzugt im Bereich von 0,1 mm bis 4 mm, weiter bevorzugt im Bereich von 0,2 mm bis 2 mm aufweist, und/oder
wobei das erste und/oder das zweite Substrat eine laterale Abmessung im Bereich von 30 mm bis 1000 mm, bevorzugt im Bereich von 50 mm bis 500 mm aufweist.

14. Verfahren nach einem der vorhergehenden Ansprüche,
wobei eine Mehrzahl von Vereinzelungsbereichen in die beiden Substrate eingebracht wird,
wobei die Mehrzahl von Vereinzelungsbereichen bevorzugt ein Raster definiert.

15. Verschweißte Substrate, umfassend:
mindestens ein erstes Substrat (10) und ein zweites Substrat (20),
wobei das erste und das zweite Substrat (10, 20) miteinander in Kontakt stehen, so dass ein Kontaktbereich (100) zwischen den beiden Substraten gebildet ist,
mindestens zwei äußere Schweißlinien (110), die nebeneinander innerhalb des Kontaktbereichs (100) in dem ersten und dem zweiten Substrat (10, 20) verlaufen, so dass das erste und das zweite Substrat (10, 20) durch jede der äußeren Schweißlinien miteinander verschweißt sind und so dass zwischen den beiden äußeren Schweißlinien ein Vereinzelungsbereich (200) definiert ist,
mindestens vier innere Schweißlinien (210), die in mindestens einem der beiden Substrate (10, 20) zwischen den beiden äußeren Schweißlinien (110) innerhalb des Vereinzelungsbereichs (200) verlaufen.

16. Verschweißte Substrate gemäß dem vorhergehenden Anspruch, ferner umfassend:
ein drittes Substrat (30),
wobei das zweite und das dritte Substrat (20, 30) derart miteinander in Kontakt stehen, dass ein Kontaktbereich (200) zwischen den beiden Substraten gebildet ist,
mindestens zwei äußere Schweißlinien (110), die innerhalb des Kontaktbereichs nebeneinander in dem zweiten und dem dritten Substrat (20, 30) verlaufen, so dass das zweite und das dritte Substrat (20, 30) durch jede der äußeren Schweißlinien miteinander verschweißt sind und so dass zwischen den beiden äußeren Schweißlinien ein Vereinzelungsbereich (200) definiert ist,
eine oder mehrere innere Schweißlinien (210), die in mindestens einem der beiden Substrate (20, 30) zwischen den beiden äußeren Schweißlinien (110) innerhalb des Vereinzelungsbereichs (200) verlaufen.

17. Vereinzelter Chip (1), insbesondere hermetisch abgedichtete Einhäusung, umfassend mindestens ein erstes Substrat (10) und ein zweites Substrat (20),
wobei das erste und das zweite Substrat (10, 20) miteinander in Kontakt stehen und durch Schweißlinien miteinander verschweißt sind,
wobei ein Funktionsbereich (400) definiert ist, der durch Schweißlinien hermetisch eingeschlossen ist, und wobei mindestens zwei weitere Schweißlinien oder partielle Schweißlinien (310) am Seitenrand mindestens eines Substrats angeordnet sind.

18. Vereinzelter Chip (1) gemäß dem vorhergehenden Anspruch, ferner umfassend:
ein drittes Substrat (30),
wobei das zweite und das dritte Substrat (20, 30) miteinander in Kontakt stehen und durch Schweißlinien miteinander verschweißt sind,
wobei ein Hohlraum (500) gebildet ist, der durch Schweißlinien hermetisch eingeschlossen ist, und wobei mindestens eine Schweißlinie oder eine partielle Schweißlinie (310) am Seitenrand mindestens eines Substrats angeordnet ist.

## Revendications

1. Procédé de soudage de substrats comprenant :
d'amener un premier substrat (10) et un second substrat (20) en contact ensemble de telle manière qu'une surface de contact (100) entre les deux substrats est formée,
d'introduire au moins deux lignes de soudure extérieures (110) s'étendant côte à côte dans la surface de contact (100) dans les premier et second substrats (10, 20) de telle manière que les premier et second substrats (10, 20) sont soudés ensemble par chacune des lignes de soudure extérieures (110) de telle manière qu'une zone de découpage (200) et définie entre les deux lignes de soudure extérieures (110),
d'introduire au moins quatre lignes de soudure intérieures (210) s'étendant entre les deux lignes de soudure extérieures (110) dans la zone de découpage dans au moins un des deux substrats.

2. Procédé selon l'une quelconque des revendications précédentes, comprenant en outre :
de découper les substrats soudés en de multiples puces séparées en découpant les substrats soudés dans la zone de découpage,
dans lequel de préférence le découpage est réalisé sur au moins une des lignes de soudure intérieures dans la zone de découpage.

3. Procédé selon l'une quelconque des revendications précédentes,
dans lequel le découpage des substrats soudés est réalisé au moyen d'une lame de sciage,
dans lequel de préférence la lame de sciage saisit au moins une des lignes de soudure intérieures s'étendant dans la zone de découpage.

4. Procédé selon l'une quelconque des revendications précédentes,
dans lequel la découpe des substrats soudés est réalisée par rainurage puis cassure.

5. Procédé selon l'une quelconque des revendications précédentes,
dans lequel le découpage des substrats soudés est réalisé par perforation laser dans laquelle des perforations adjacentes sont introduites dans les substrats puis par une gravure subséquente dans laquelle un fluide de gravure est utilisé pour connecter les perforations adjacentes et/ou par une application subséquente d'une contrainte, par exemple une contrainte mécanique et/ou une contrainte thermique.

6. Procédé selon l'une quelconque des revendications précédentes,
dans lequel la section transversale d'une ligne de soudure extérieure et/ou intérieure est **caractérisée par** au moins une des caractéristiques suivantes :
une surface d'absorption non linéaire (350),
un bombement allongé (360), de préférence commençant à partir de la surface d'absorption non linéaire,
une région de fusion (370), entourant de préférence le bombement allongé,
une région de chauffage (380), de préférence entourant le bombement allongé et/ou la région de fusion.

7. Procédé selon l'une quelconque des revendications précédentes,
dans lequel la surface de contact a une largeur de moins de 5 mm, de préférence de moins de 2 mm, plus préférablement de moins de 1 mm, le plus préférablement de 0,6 mm et/ou
dans lequel la surface de contact a une largeur de plus de 0,1 mm, préférablement de plus de 0,4, plus préférablement de plus de 0,6 mm.

8. Procédé selon l'une quelconque des revendications précédentes,
dans lequel la zone de découpage a une largeur de moins de 2 mm, de préférence de moins de 1 mm, plus préférablement de moins de 0,3 mm et/ou
dans lequel la zone de découpage a une largeur de plus de 0,05 mm, préférablement de plus de 0,1 mm, plus préférablement de plus de 0,2 mm.

9. Procédé selon l'une quelconque des revendications précédentes,
dans lequel au moins 8 lignes de soudure intérieures sont introduites, et/ou
dans lequel deux lignes de soudures intérieures adjacentes ont une distance d entre elles qui est inférieure à 0,3 mm, de préférence inférieure à 0,15 mm, plus préférablement inférieure à 0,05 mm, et/ou
dans lequel les lignes de soudures intérieures sont introduites de telle manière que la fraction d/w est inférieure à 3, de préférence inférieure à 2, dans lequel d est la distance entre des lignes de soudures intérieures adjacentes et w est la largeur de la zone de découpage.

10. Procédé selon l'une quelconque des revendications précédentes, comprenant en outre :
de définir une force de cisaillement minimale Fₘᵢₙ que la soudure des premier et second substrats doit supporter, et
d'introduire un nombre lignes de soudure extérieures et/ou intérieures de façon à obtenir la force de cisaillement minimale définie Fₘᵢₙ.

11. Procédé selon l'une quelconque des revendications précédentes,
dans lequel au moins 2 lignes de soudures extérieures sont introduites sur chaque côté de la zone de découpage, de préférence au moins 3 lignes de soudures extérieures sont introduites sur chaque côté de la zone de découpage, plus préférablement au moins 4 lignes de soudures extérieures sont introduites sur chaque côté de la zone de découpage, et/ou
dans lequel deux lignes de soudures extérieures adjacentes ont une distance d entre elles qui est inférieure à 0,3 mm, de préférence inférieure à 0,15 mm, plus préférablement inférieure à 0,05 mm.

12. Procédé selon l'une quelconque des revendications précédentes,
dans lequel le premier substrat comprend un des matériaux suivants : verre, céramique de verre, verre de borosilicate, cristal, saphir, diamant, silicium, métal et/ou
dans lequel le second substrat comprend un des matériaux suivants : verre, céramique de verre, verre de borosilicate, cristal, saphir, diamant, silicium, métal.

13. Procédé selon l'une quelconque des revendications précédentes,
dans lequel le premier et/ou le second substrat a une épaisseur dans la plage de 0,03 mm à 20 mm, préférablement dans la plage de 0,1 mm à 4 mm, plus préférablement dans la plage de 0,2 mm à 2 mm et/ou
dans lequel le premier et/ou le second substrat ont une dimension latérale dans la plage de 30 mm à 1000 mm, préférablement dans la plage de 50 mm à 500 mm.

14. Procédé selon l'une quelconque des revendications précédentes, dans lequel une pluralité de zones de découpage sont introduites dans les deux substrats,
dans lequel de préférence la pluralité de zones de découpage définissent une grille.

15. Substrats soudés comprenant :
au moins un premier substrat (10) et un second substrat (20),
dans lequel les premier et second substrats (10, 20) sont en contact ensemble de telle manière qu'une surface de contact (100) entre les deux substrats est formée,
au moins deux lignes de soudure extérieures (110) s'étendant côte à côte dans la surface de contact (100) dans les premier et second substrats (10, 20) de telle manière que les premier et second substrats (10, 20) sont soudés ensemble par chacune des lignes de soudures extérieures et de telle manière qu'une zone de découpage (200) est définie entre les deux lignes de soudures extérieures,
au moins quatre lignes de soudure intérieures (210) s'étendant entre les deux lignes de soudure extérieures (110) dans la zone de découpage (200) dans au moins un des deux substrats (10, 20).

16. Substrats soudés selon la revendication précédente comprenant en outre :
un troisième substrat (30),
dans lequel les second et troisième substrats (20, 30) sont en contact ensemble de telle manière qu'une surface de contact (200) entre les deux substrats est formée,
au moins deux lignes de soudure extérieures (110) s'étendant côte à côte dans la surface de contact (200) dans les second et troisième substrats (20, 30) de telle manière que les second et troisième substrats (20, 30) sont soudés ensemble par chacune des lignes de soudures extérieures et de telle manière qu'une zone de découpage (200) est définie entre les deux lignes de soudures extérieures,
une ou plusieurs lignes de soudure intérieures (210) s'étendant entre les deux lignes de soudure extérieures (110) dans la zone de découpage (200) dans au moins un des deux substrats (20, 30).

17. Puce séparée (1), en particulier enceinte hermétiquement scellée, comprenant
au moins un premier substrat (10) et un second substrat (20), dans lequel les premier et second substrats (10, 20) sont en contact ensemble et sont soudés ensemble par des lignes de soudure,
dans lequel une zone fonctionnelle (400) est définie qui est hermétiquement enclose par des lignes de soudure, et dans lequel au moins deux autres lignes de soudure ou lignes de soudure partielles (310) sont positionnées au niveau du bord latéral d'au moins un substrat.

18. Puce séparée (1) selon la revendication précédente comprenant en outre :
un troisième substrat (30),
dans lequel les second et troisième substrats (20, 30) sont en contact ensemble et sont soudés ensemble par des lignes de soudure,
dans lequel une cavité (500) est définie qui est hermétiquement enclose par des lignes de soudure, et dans lequel au moins une ligne de soudure ou une ligne de soudure partielle (310) est positionnée au niveau du bord latéral d'au moins un substrat.
